# FASCICULE DE BREVET EUROPEEN

(11) **EP 0 298 794 B1**
(45) Date de publication et mention de la délivrance du brevet: **06.04.1994**
(21) Numéro de dépôt: 88401452.3
(22) Date de dépôt: 13.06.1988
(51) Int. Cl.: H01L 21/76, H01L 21/265

(54) **Procédé de fabrication d'une couche d'isolant enterrée dans un substrat semi-conducteur par implantation ionique et structure semi-conductrice comportant cette couche**
Verfahren zur Herstellung einer vergrabenen isolierenden Schicht in einem Halbleitersubstrat durch Ionenimplantation und Halbleiterstruktur mit einer solchen Schicht
Process for making a buried insulating layer in a semiconductor substrate by ion implantation and semiconductor structure comprising such a layer

(30) Priorité: 15.06.1987 FR 8708272
(43) Date de publication de la demande: 11.01.1989
(73) Titulaire: COMMISSARIAT A L'ENERGIE ATOMIQUE, 75015 Paris Cédex 15 (FR)
(72) Inventeur: Margail, Jacques, F-38100 Grenoble (FR); Stoemenos, John, Thessalonique (FR)
(74) Mandataire: Des Termes, Monique

(56) Documents cités:
- ELECTRONICS LETTERS, vol. 22, no. 9, 24 avril 1986, pages 467-469; K.J. REESON et al.: "Formation of multilayer Si3N4 structures by nitrogen ion implantation"
- JAPANESE JOURNAL OF APPLIED PHYSICS, vol. 20, no. 12, décembre 1981, pages L909-L912; Y. IRITA et al.: "Multiple SOI structure fabricated by high dose oxygen implantation and epitaxial growth"
- PATENT ABSTRACTS OF JAPAN, vol. 7, no. 148 (E-184), 29 juin 1983, page 91 E 184; & JP-A-58 60 556
- IEEE TRANSACTIONS ON ELECTRON DEVICES, vol. ED-33, no. 3, mars 1986, pages 354-360, IEEE; D.J. FOSTER et al.: "Optimization of oxygen-implanted silicon substrates for CMOS devices by electrical characterization"
- SOLID STATE TECHNOLOGY, vol. 30, no. 3, mars 1987, pages 93-98; G.K. CELLER: "Silicon-on-insulator films by oxygen implantation and lamp annealing"
- APPLIED PHYSICS LETTERS, vol. 50, no. 1, 5 janvier 1987, pages 19-21, American Institute of Physics; A.E. WHITE et al.: "Mechanisms of buried oxide formation by ion implantation"

## Description

La présente invention a pour objet un procédé de fabrication d'une couche continue d'oxyde, enterrée dans un substrat semi-conducteur, par implantation d'ions oxygène dans le substrat ainsi que des structures semi-conductrices comportant cette couche enterrée d'oxyde.

Elle s'applique en particulier dans le domaine de la fabrication de circuits intégrés MIS (métal-isolant-semi-conducteur), CMOS (métal-oxyde-semi-conducteur complémentaire) ou circuits bipolaires du type silicium sur isolant, présentant une grande rapidité de fonctionnement, éventuellement une grande résistance aux radiations ionisantes et devant dissiper de fortes puissances. Elle s'applique aussi dans le domaine de l'optique guidée, éventuellement intégrée, pour la réalisation de guide de lumière plans ou rubans.

La technologie silicium sur isolant ou technologie SSI constitue une amélioration sensible dans le domaine de la microélectronique par rapport aux techniques standard dans lesquelles les composants actifs des circuits intégrés sont réalisés directement sur un substrat monocristallin en silicium massif. En effet, l'emploi d'un support isolant conduit à une forte diminution des capacités parasites entre la source et le substrat d'une part, et le drain et le substrat d'autre part, des composants actifs des circuits et donc à un accroissement de la vitesse de fonctionnement de ces circuits.

Cette technologie SSI conduit aussi à une simplification notable des procédés de fabrication, à une augmentation de la densité d'intégration, à une meilleure tenue aux hautes tensions et à une faible sensibilité aux rayonnements du fait que le volume de silicium monocristallin est faible.

L'une des technologies SSI actuellement connues consiste à implanter des ions d'oxygène O⁺ à fortes doses dans du silicium monocristallin massif permettant de former, après un recuit du substrat à haute température, une couche isolante enterrée d'oxyde de silicium. Ce procédé connu sous le nom de procédé SIMOX (separation by implanted oxygen en terminologie anglo-saxonne) a fait l'objet d'un grand nombre de publications.

A cet effet, on peut citer l'article de P.L.F. Hemment "Silicon on insulator formed by O⁺ or N⁺ ion implantation" paru dans Mat. Res. Soc. Symp. vol. 53, 1986 ; l'article de J. Stoemenos et al. "New conditions for synthesizing SOI structures by high dose oxygen implantation", paru dans Journal of Crystal Growth 73 (1985) 546-550 ; l'article de M. Bruel et al. "High temperature annealing of SIMOX layers", paru dans E-MRS- Strasbourg, juin 1986, p. 105-119 ; l'article de J. Stoemenos et al. paru dans Appl. Phys. Lett. 48 (21), du 26 mai 1986, p. 1470-1472, intitulé "SiO₂ buried layer formation by subcritical dose oxygen ion implantation" ou encore l'article de G. K. Celler et al. "High quality Si-On-SiO₂ films by large dose oxygen implantation and lamp annealing", paru dans Appl. Phys. Lett. 48 (8), du 24 février 1986, p.532-534.

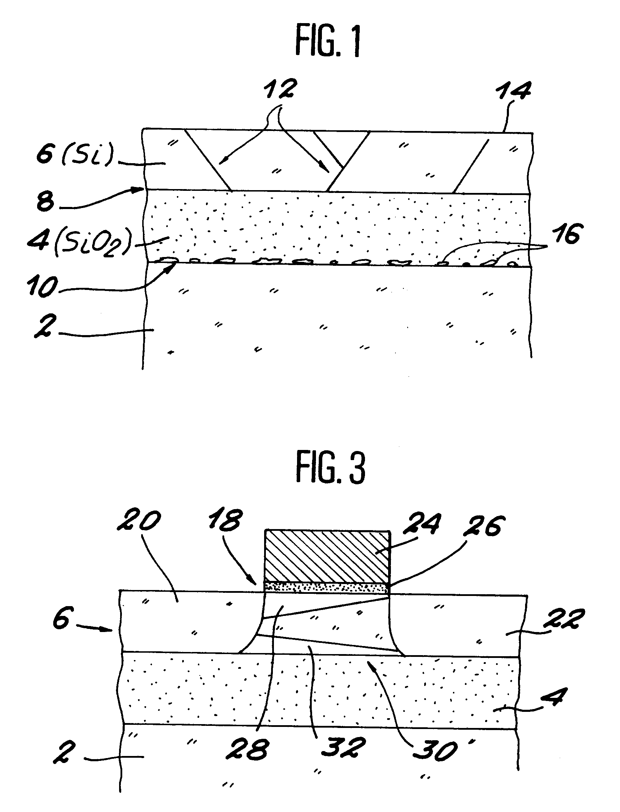

Sur la figure 1, on a représenté schématiquement en coupe longitudinale, la structure semi-conductrice obtenue conformément au procédé SIMOX. Cette structure comporte un substrat massif 2 en silicium monocristallin surmonté d'une couche 4 d'oxyde de silicium (SiO₂), elle-même recouverte d'un film 6 de silicium monocristallin.

L'interface 8 Si/SiO₂ entre le film monocristallin 6 et la couche d'oxyde 4 est appelée "interface avant" et l'interface 10 Si/SiO₂ entre le substrat massif 2 et la couche d'oxyde 4 est appelée "interface arrière".

Les conditions standard de la technologie SIMOX pour la formation d'une couche d'oxyde sont : des doses d'implantations d'oxygène de 1,6 à 2,5.10¹⁸ions O⁺/cm², une énergie d'implantation de 200 keV, un chauffage du substrat pendant l'implantation à une température allant de 500 à 700°C, puis un recuit à haute température pour parfaire la formation de la couche de silice enterrée, à des températures allant de 1150 à 1405°C. En particulier, le recuit est effectué à 1300°C pendant 6 heures (voir les articles ci-dessus de Stoemenos et de Bruel) ou à 1405°C pendant 30 minutes comme décrit dans l'article de Celler.

Le recuit haute température induit une ségrégation de tout l'oxygène implanté vers l'intérieur de la couche enterrée d'oxyde de silicium. En particulier, le film de silicium 6 surmontant la couche d'oxyde 4 ne contient plus aucun précipité d'oxyde comme indiqué dans l'article de Bruel.

Le document Japanese Journal of Appl. Phys., vol.20, n°12, 1981, L909-L912 décrit la fabrication d'une succession de couches de SiO₂ enterrées par implantations d'ions O₂+ à des doses de 5x10¹⁷ ions/cm² dans du silicium, suivies d'un recuit à 1150°C puis d'épitaxies de silicium. Une couche enterrée épaisse peut de plus être fabriquée si les couches épitaxiales sont assez minces pour que deux couches de SiO₂ successives se recouvrent partiellement.

Le procédé SIMOX largement employé présente un certain nombre d'inconvénients. En particulier, le passage des ions oxygène dans le silicium endommage plus ou moins le film de silicium monocristallin 6, créant des défauts référencés 12 sur la figure 1, souvent irréparables. Ces défauts sont en particulier des dislocations dites traversantes ancrées à l'interface 8 Si/SiO₂, traversant le film de silicium 6 et débouchant à la surface 14 de ce film. Leur densité varie entre 10⁶ et 10¹⁰/cm².

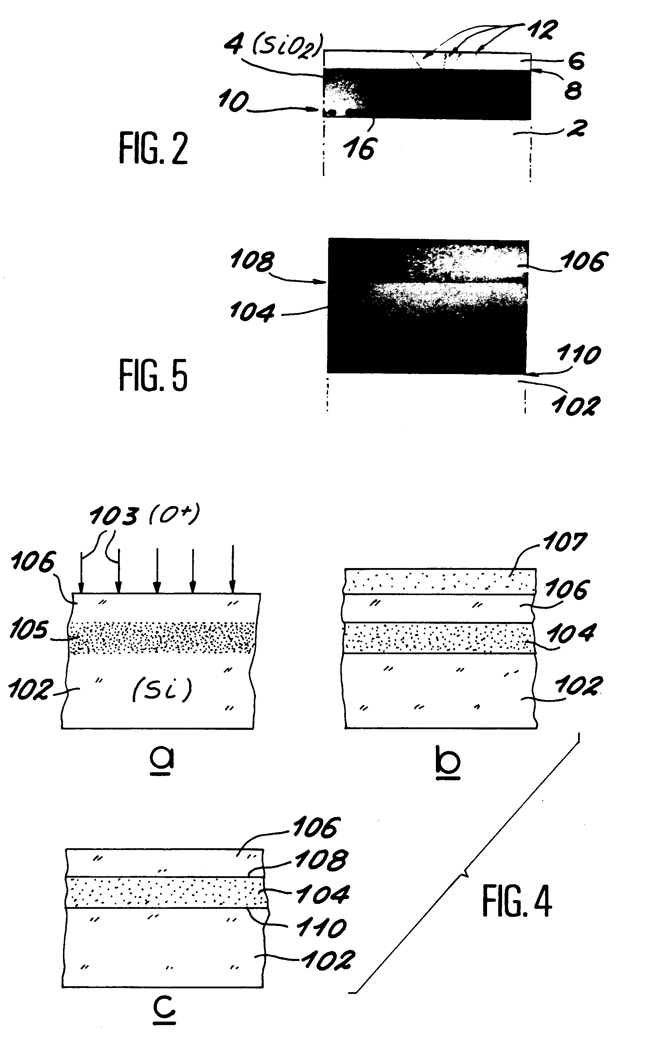

Sur la figure 2, qui est un cliché d'une structure semi-conductrice obtenue en implantant des ions d'oxygène à une dose de 1,6.10¹⁸ ions/cm² dans un substrat en silicium chauffé à 600°C, puis en recuisant le substrat à 1300°C pendant 6 heures, les dislocations traversant le film de silicium monocristallin apparaissent clairement. Ce cliché est une microscopie par transmission électronique sur tranche (X TEM).

Ces défauts ou dislocations du film de silicium entraînent une diminution des performances des composants électriques fabriqués ultérieurement dans la couche semi-conductrice 6 en pouvant être par exemple la source de fuite de jonction engendrant ainsi des courants de fuite importants.

Dans le domaine de l'optique guidée, ces dislocations perturbent la lumière véhiculée par la couche de silice enterrée entraînant des pertes de lumière.

Par ailleurs, la qualité de la couche d'oxyde de silicium enterrée n'est pas parfaite. En particulier, celle-ci comporte des ilôts de silicium 16 qui sont très gênants notamment en micro-électronique dans la mesure où ils diminuent la tenue en tension de la couche d'oxyde 4 et peuvent représenter des sites privilégiés pour le piégeage de charges. Ces ilôts de silicium apparaissent clairement sur la figure 2.

La présence des ilôts ou précipités de silicium dans la couche d'oxyde est particulièrement gênante dans le cas de transistors MIS réalisés dans le film semi-conducteur 6.

A cet effet, on a représenté sur la figure 3 un transistor avant 18 comportant une source 20 et un drain 22 définis respectivement par implantation d'ions de type n ou p dans le film monocristallin 6 ainsi qu'une grille 24 généralement réalisée en silicium polycristallin, surmontant le film de silicium 6 et isolée de celui-ci par l'oxyde de grille 26. Le canal 28 du transistor avant 18 est défini sous l'oxyde de grille 26, entre la source et le drain de ce transistor.

Associé à ce transistor avant 18, on trouve un transistor arrière 30 dont le canal 32 est situé entre la source 20 et le drain 22 ; la couche d'oxyde enterrée 4 joue le rôle d'oxyde de grille et le substrat massif en silicium 2 joue le rôle de grille de ce transistor arrière.

La présence des ilôts de silicium 16 dans la couche d'oxyde enterrée 4 peut jouer en particulier le rôle de grille flottante et modifier la tension de seuil de ce transistor arrière 30 pouvant ainsi entraîner son déclenchement intempestif.

L'emplacement précis de ces ilôts de silicium 16 dépend de la dose d'implantation des ions oxygène. En effet, pour de faibles doses d'implantation, inférieures à 1,4.10¹⁸ ions/cm², ces ilôts 16 se trouvent à l'intérieur de la couche d'oxyde 4, comme le montre la figure 2 de l'article ci-dessus de Stoemenos paru dans Appl. Phys. Lett.

Dans le cas de doses comprises entre 1,4 et 1,6.10¹⁸ ions/cm², la présence de ces ilôts de silicium est limitée aux interfaces Si/SiO₂ avant 8 et arrière 10 (figure 1) comme le montre la figure 5 de l'article de Bruel.

Enfin pour des doses plus élevées, supérieures à 1,6.10¹⁸ ions/cm², on observe la présence de ces ilôts de silicium uniquement à proximité de l'interface arrière 10 comme décrit dans l'article de Stoemenos paru dans Journal of Crystal Growth. C'est cette dernière configuration qui est représentée sur les figures 1 et 2.

La formation de ces ilôts de silicium, encore appelés précipités de silicium, a été expliquée dans l'article de Bruel ; elle résulte de l'évolution après le recuit à haute température (1300°C environ) d'interfaces Si/SiO₂ non abruptes, ces interfaces présentant une structure lamellaire. La formation de ces ilôts est inévitable.

Etant donné que le coefficient de diffusion du silicium à travers l'oxyde de silicium est extrèmement faible (de l'ordre de 10⁻²⁹/cm² à 400°C), les inventeurs ont trouvé que la seule façon d'éliminer les précipités de silicium de la couche d'oxyde était de les oxyder. Le procédé selon l'invention permet cette oxydation des précipités de silicium.

Par ailleurs, les inventeurs ont mis en évidence dans un article "Self-interstitial migration in Si implanted with oxygen" paru dans Physica Scripta, vol. 35, 42-44 de 1987 que la formation de la couche enterrée d'oxyde de silicium 4 (figure 1) met en jeu un flux important, vers la surface 14 de la structure, d'atomes de silicium déplacés hors de leurs sites dans le cristal et se trouvant donc en site interstitiel.

Lors de l'implantation, les précipités d'oxyde de silicium qui se forment dans le film monocristallin 6 bloquent "la migration" vers la surface 14 des atomes interstitiels de silicium qui ont donc tendance à se condenser sous la forme de boucles de dislocation, de part et d'autre de la couche enterrée d'oxyde. Le nombre de boucles de dislocation augmente avec la dose d'ions oxygène implantés. Ce sont ces boucles de dislocation qui, après recuit à haute température, donnent lieu à la formation des dislocations traversantes 12 dans le film semi-conducteur.

Le procédé selon l'invention en plus de l'élimination des précipités de silicium présents dans la couche d'oxyde de silicium permet de diminuer la densité des dislocations, et en particulier des dislocations traversantes, présentes dans le film de silicium surmontant la couche d'oxyde de silicium.

A cet effet, le procédé selon l'invention a trait à la fabrication d'une couche continue d'oxyde, enterrée dans un substrat semi-conducteur, consistant à effectuer dans le substrat au moins deux implantations successives d'ions oxygène, lesdites implantations successives étant séparées uniquement par une étape de recuit, à une même énergie et à une dose dans le substrat inférieure à 1,5.10¹⁸ ions O+/cm², chaque implantation étant suivie directement d'une étape de recuit de la structure obtenue à une température supérieure à 800°C mais inférieure à la température de fusion du substrat, la première implantation suivie de la première étape de recuit formant une couche isolante enterrée d'oxyde et les implantations suivantes avec leur recuit améliorant la structure de ladite couche enterrée d'oxyde.

Ce procédé permet d'une part de diminuer fortement le taux de dislocation du film semi-conducteur formé au-dessus de la couche d'oxyde enterrée, et d'autre part d'éliminer la présence des précipités de matériaux semi-conducteurs observés dans la couche enterrée isolante par oxydation de ces précipités lorsque l'on implante des ions oxygène.

Conformément à l'invention, on effectue l'implantation d'ions oxygène en plusieurs étapes. La dose d'ions implantés à chaque implantation ionique est inférieure à la dose totale d'ions que l'on désire implanter. En outre, le nombre d'implantations est fonction de la dose totale d'ions que l'on désire voir implanter et de la dose d'ions implantés à chaque implantation.

La dose totale d'ions dépend des épaisseurs de la couche d'oxyde et du film monocristallin surmontant cette couche isolante que l'on désire obtenir. Pour une énergie d'implantation donnée, l'épaisseur de la couche d'oxyde croît avec le nombre et la dose d'implantation et inversement, l'épaisseur du film monocristallin surmontant la couche d'oxyde décroît avec le nombre et la dose d'implantation.

A titre d'exemple, pour plusieurs implantations d'ions oxygène avec une énergie de 200 keV, dans du silicium, la dose totale d'ions implantés doit être inférieure à 3,8.10¹⁸ ions O⁺/cm² ; au-dessus de cette valeur, il n'y a plus de film de silicium et la couche isolante n'est plus enterrée.

Par ailleurs, le nombre d'implantations et la dose d'ions implantés à chaque implantation dépend de la nature des ions et de la nature du substrat dans lequel ces ions sont implantés.

Dans le cas d'une implantation d'ions O⁺ dans un substrat en silicium, le nombre d'implantations peut par exemple varier de 2 à 10 et la dose d'ions implantés à chaque implantation varier de 10¹⁶ à 0,9.10¹⁸ ions O⁺/cm². En particulier pour une couche d'oxyde de silicium enterrée respectivement de 330 et de 400 nm d'épaisseur pour un film de silicium monocristallin respectivement de 260 et de 200 nm, on peut utiliser respectivement 5 et 6 implantations ioniques d'oxygène, à des doses de 3.10¹⁷ ions O⁺/cm², ce qui correspond à une monoimplantation de respectivement 1,5 et 1,8.10¹⁸ ions/cm².

Les énergies d'implantation, qui sont identiques d'une implantation à l'autre, sont fonction de la profondeur de pénétration des ions ; plus l'énergie croît, plus la profondeur de pénétration croft. Les énergies sont par exemple comprises entre 100 et 1000 keV.

Conformément à l'invention, on peut par exemple implanter des ions d'oxygène dans un substrat en silicium monocristallin.

Pour un substrat en silicium, l'implantation d'ions oxygène conduit à l'obtention d'une couche enterrée en SiO₂.

Afin de réaliser un recuit in-situ des défauts cristallins créés par l'implantation ionique, autrement dit afin d'éviter de rendre amorphe le film semi-conducteur et d'améliorer sa qualité, on effectue avantageusement, pendant l'implantation, un chauffage du substrat. Ce chauffage pour un substrat en silicium varie de 500 à 700°C.

La température du recuit suivant chaque implantation ionique dépend de la nature du substrat semi-conducteur. En outre, plus la température de recuit est élevée, plus la durée de ce recuit sera courte. Pour un substrat en silicium, la température du recuit est supérieure à 1100°C et peut aller de 1150 à 1400°C et avantageusement aller de 1300 à 1400°C ; la température de fusion du silicium est égale à 1415°C.

Le procédé selon l'invention permet la réalisation de structures semi-conductrices comportant une couche d'oxyde intercalée entre un substrat semi-conducteur et un film semi-conducteur, obtenue par implantation ionique d'oxygène dans le substrat, dans lesquelles le film semi-conducteur présente un taux de dislocations inférieur à 10⁵ par cm² et la couche isolante est homogène.

La valeur 10⁵ par cm² est due à la limite de détection par microscopie électronique planaire actuelle.

D'autres caractéristiques et avantages de l'invention ressortiront mieux de la description qui va suivre, donnée à titre illustratif et non limitatif.

La description se réfère aux figures annexées, dans lesquelles :
- la figure 1, déjà décrite, représente schématiquement, en coupe longitudinale, une structure obtenue par le procédé SIMOX conformément à l'art antérieur,
- la figure 2 est un cliché en microscopie par transmission électronique sur tranche d'une structure obtenue en implantant des ions oxygène dans du silicium monocristallin selon l'art antérieur,
- la figure 3, déjà décrite, représente schématiquement, un transistor MOS réalisé dans une couche de silicium surmontant une couche d'oxyde de silicium,
- la figure 4 illustre le procédé de fabrication d'une couche d'oxyde de silicium enterrée, et
- la figure 5 est un cliché en microscopie par transmission électronique sur tranche d'une structure obtenue avec le procédé selon l'invention.

Dans un exemple de mise en oeuvre particulier du procédé selon l'invention, illustré sur la figure 4, on effectue, dans un substrat en silicium monocristallin 102, une première implantation d'ions O⁺ 103 à une dose de 0,8.10¹⁸ ions/cm² avec une énergie de 200 keV. On obtient une couche d'oxygène implantée 105 surmontée d'un film 106 de silicium monocristallin, comme indiqué sur la partie (a) de la figure 4. Un chauffage du substrat à une température de l'ordre de 600°C, pendant l'implantation, constitue en particulier une étape de recuit permettant d'améliorer la qualité cristalline du film semi-conducteur 106.

On effectue ensuite un dépôt chimique en phase vapeur assisté par plasma (PECVD) d'une couche d'encapsulant 107 d'oxyde de silicium de 600 nm d'épaisseur, comme illustré sur la partie (b) de la figure 4, assurant une protection du film de silicium 106 lors du recuit à haute température. Ce recuit est effectué à 1320°C pendant 6 heures.

Conformément à l'invention, la première implantation ionique suivie du premier recuit à haute température (supérieure à 1100°C) conduit à une couche enterrée 104 d'oxyde de silicium SiO₂ contenant de très nombreux précipités ou ilôts de silicium localisés à l'intérieur de la couche d'oxyde de silicium comme illustré dans l'article Appl. Phys. Lett. de Stoemenos cité précédemment.

On élimine ensuite la couche d'encapsulation par une gravure chimique avec un bain d'attaque comprenant du FH et du FNH₄.

On effectue alors une nouvelle implantation ionique d'oxygène à une dose de 0,8.10¹⁸ ions/cm², avec une énergie de 200 keV. On dépose à nouveau une couche d'encapsulant 107 par PECVD puis on effectue un nouveau recuit à 1320°C pendant 6 heures.

La deuxième implantation suivie de son recuit a pour rôle d'apporter l'oxygène nécessaire à l'oxydation des précipités de silicium présents dans la couche d'oxyde enterrée 104 et de conduire ainsi à des interfaces Si/SiO₂ avant 108 et arrière 10 abruptes.

Après élimination de la seconde couche d'encapsulation, on obtient la structure semi-conductrice représentée sur la partie (c) de la figure 4.

Les deux implantations successives conduisent à une dose totale implantée de 1,6.10¹⁸ ions/cm².

Ce mode opératoire permet d'obtenir une couche d'oxyde de silicium 104 de 380 nm d'épaisseur, et un film semi-conducteur 106 de l'ordre de 170 nm d'épaisseur.

La structure obtenue dans ces conditions est représentée sur le cliché de la figure 5. Il ressort clairement de ce cliché qui a été établi en microscopie X par transmission électronique sur tranche connue sous l'abréviation X TEM que le film de silicium 106 surmontant la couche d'oxyde de silicium enterrée 104 est exempte de dislocations traversantes. Une caractérisation en TEM a montré que la densité de dislocations dans le film de silicium est inférieure à 10⁵ par cm². Par ailleurs, la couche d'oxyde 104 est dépourvue d'ilôts de silicium et les interfaces avant et arrière 108 et 110 de Si/SiO₂ sont abruptes. Ceci est très important pour la réalisation de façon industrielle de circuits intégrés ou de guides d'onde ayant d'excellentes qualités respectivement électriques et optiques.

Le procédé selon l'invention conduit à la réalisation de structures silicium sur isolant d'excellente qualité. Il permet la réalisation de structures SIMOX contenant une très faible quantité de dislocations, inférieur à 10⁵/cm² et comportant une couche d'oxyde de silicium enterrée exempte d'ilôts de Si et parfaitement homogène.

Le procédé selon l'invention ne remet pas en cause le caractère industriel de la fabrication des structures SIMOX mais permet en revanche une amélioration de la qualité de la couche de silicium monocristallin, rendant ainsi ce type de matériau plus compatible avec les exigences industrielles.

Le procédé selon l'invention en dehors de la réalisation des circuits intégrés en technologie SSI peut être avantageusement utilisé pour la réalisation de guides d'onde en optique intégrée sur un substrat en silicium. Ces guides d'onde sont constitués d'une ou plusieurs couches de SiO₂ réalisées par implantation ionique d'oxygène conformément à l'invention avec des énergies d'implantations différentes, la profondeur d'implantation des ions croissant avec l'énergie d'implantation.

Il est de plus possible de réaliser l'implantation d'ions après avoir recouvert le substrat semi-conducteur par une couche encapsulante en SiO₂. L'utilisation de cette couche d'encapsulation est en particulier décrite dans l'article de Bruel cité précédemment.

## Revendications

1. Procédé de fabrication d'une couche continue d'oxyde (104), enterrée dans un substrat semi-conducteur (102), consistant à effectuer dans le substrat au moins deux implantations successives d'ions oxygène, lesdites implantations successives étant séparées uniquement par une étape de recuit, à une même énergie et à une dose dans le substrat inférieure à 1,5.10¹⁸ions O+/cm², chaque implantation étant suivie directement d'une étape de recuit de la structure obtenue, à une température supérieure à 800°C mais inférieure à la température de fusion du substrat, la première implantation suivie de la première étape de recuit formant une couche isolante (104) enterrée d'oxyde et les implantations suivantes avec leur recuit améliorant la structure de ladite couche enterrée d'oxyde.

2. Procédé selon la revendication 1, caractérisé en ce que le nombre d'implantations et la dose d'ions implantés dépendent de la dose totale d'ions que l'on désire voir implanter.

3. Procédé selon la revendication 1 ou 2, caractérisé en ce que le substrat (102) est du silicium.

4. Procédé selon la revendication 3, caractérisé en ce que les recuits sont effectués à une température supérieure à 1100°C.

5. Procédé selon la revendication 3 ou 4, caractérisé en ce que les recuits sont effectués à une température allant de 1300°C à 1400°C.

6. Procédé selon l'une quelconque des revendications 1 à 5, caractérisé en ce que l'étape de recuit comporte les stades suivants : dépôt sur la structure d'une couche d'encapsulation, traitement thermique et élimination de la couche d'encapsulation.

7. Procédé selon l'une quelconque des revendications 1 à 6, caractérisé en ce que l'on effectue, pendant chaque implantation, un chauffage du substrat (102), un recuit in-situ des défauts cristallins créés par l'implantation ionique étant ainsi réalisé.

8. Procédé selon la revendication 7, caractérisé en ce que le chauffage du substrat (102) est effectué à une température allant de 500 à 700°C pour un substrat en silicium.

9. Procédé selon la revendication 1, caractérisé en ce que le substrat est en silicium, le nombre d'implantations est 2, chaque implantation est effectuée à une dose dans le substrat de 0,8.10¹⁸ ions O+/cm² avec une énergie de 200 keV, et le recuit est effectué à 1320°C pendant 6 heures.

## Claims

1. Process for the production of a continuous oxide layer (104), buried in a semiconductor substrate (102), consisting of performing in said substrate at least two successive implantations of oxygen ions, said successive implantations being solely separated by an annealing stage, at the same energy and at a dose in the substrate below 1.5·10¹⁸ ions O⁺/cm², each implantation being directly followed by an annealing stage for the structure obtained at a temperature above 800°C, but below the melting point of the substrate, the first implantation followed by the first annealing stage forming a buried oxide insulating layer and the following implantations with their annealing improving the structure of said buried oxide layer (104).

2. Process according to claim 1, characterized in that the number of implantations and the dose of implanted ions are a function of the total ion dose which it is wished to implant.

3. Process according to claim 1 or 2, characterized in that the substrate (102) is made from silicon.

4. Process according to claim 3, characterized in that the annealing operations are performed at a temperature exceeding 1100°C.

5. Process according to claim 3 or 4, characterized in that the annealing operations are performed at a temperature from 1300 to 1400°C.

6. Process according to any one of the claims 1 to 5, characterized in that the annealing operation involves the following stages: deposition of an encapsulating layer on the structure, heat treatment and elimination of the encapsulating layer.

7. Process according to any one of the claims 1 to 6, characterized in that, during implantation, the substrate (102) is heated, thereby carrying out an in-situ annealing of the crystalline defects created by ion implantation.

8. Process according to claim 7, characterized in that the heating of the substrate (102) takes place at a temperature from 500 to 700°C for a silicon substrate.

9. Process according to claim 1, characterized in that the substrate is made from silicon, the number of implantations is two, each implantation is performed with a dose in the substrate of 0.8·10¹⁸ ions O⁺/cm² with an energy of 200 keV and annealing is performed at 1320°C for 6 hours.

## Patentansprüche

1. Verfahren zur Herstellung einer, in einem Halbleitersubstrat (102) vergrabenen, kontinuierlichen Oxidschicht (104), die darauf beruht, daß in dem Substrat nacheinander mindestens zwei Implantationen von Sauerstoffionen ausgeführt werden, wobei die besagten Implantationen nacheinander, nur durch einen Glühschritt getrennt, bei derselben Energie und bei einer Dosis im Substrat kleiner 1,5.10¹⁸ O⁺-Ionen/cm² erfolgen, wobei jede Implantation direkt von einem Glühabschnitt der erhaltenen Struktur bei einer Temperatur größer 800°C, aber kleiner der Fusionstemperatur des Substrats gefolgt wird, und die erste Implantation von dem ersten Glühschritt gefolgt wird, der eine vergrabene isolierende Oxidschicht (104) bildet und die folgenden Implantationen mit ihrem Glühen die Struktur der besagten vergrabenen Oxidschicht verbessern.

2. Verfahren gemäß Anspruch 1, dadurch gekennzeichnet, daß die Zahl der Implantationen und die Dosis der implantierten Ionen von der Gesamtdosis der Ionen abhängt, die man zu implantieren wünscht.

3. Verfahren gemäß Anspruch 1 oder 2, dadurch gekennzeichnet, daß das Substrat (102) aus Silizium ist.

4. Verfahren gemäß Anspruch 3, dadurch gekennzeichnet, daß die Glühvorgänge bei einer Temperatur größer 1100°C erfolgen.

5. Verfahren gemäß Anspruch 3 oder 4, dadurch gekennzeichnet, daß die Glühvorgänge bei einer Temperatur zwischen 1300°C und 1400°C erfolgen.

6. Verfahren gemäß einem der Ansprüche 1 bis 5, dadurch gekennzeichnet, daß der Glühschritt die folgenden Abschnitte umfaßt: Abscheiden einer einschließenden Schicht auf einer Struktur, thermische Behandlung und Beseitigung der einschließenden Schicht.

7. Verfahren gemäß einem der Ansprüche 1 bis 6, dadurch gekennzeichnet, daß man während jeder Implantation eine Erwärmung des Substrats (102) ausführt, ein In-situ Glühen der durch die Ionenimplantation erzeugten Kristallfehler wird somit ausgeführt.

8. Verfahren gemäß Anspruch 7, dadurch gekennzeichnet, daß das Erwärmen des Substrats (102) für ein Siliziumsubstrat bei einer Temperatur zwischen 500 und 700°C ausgeführt wird.

9. Verfahren gemäß Anspruch 1, dadurch gekennzeichnet, daß das Substrat aus Silizium ist, die Zahl der Implantationen gleich 2 ist, jede Implantation bei einer Dosis im Substrat von 0,8.10¹⁸ O⁺-Ionen/cm², mit einer Energie von 200keV erfolgt, und das Glühen bei 1320°C während 6 Stunden erfolgt.
